# EUROPEAN PATENT APPLICATION

(11) **EP 3 723 108 A1**
(43) Date of publication of application: **14.10.2020**
(21) Application number: 20169011.2
(22) Date of filing: 09.04.2020
(51) Int. Cl.: H01G 2/08, H01G 4/38, H01G 4/40, H01G 4/32, H01G 2/04, H01G 2/06

(54) **INTEGRATED DC BUSBAR AND DC-LINK CAPACITOR**

(30) Priority: 12.04.2019 US 201916382825
(71) Applicant: Karma Automotive LLC, Irvine, CA 92618 (US)
(72) Inventor: NGUYEN, Khanh, Irvine, CA 92618 (US); NIU, Geng, Irvine, CA 92618 (US)
(74) Representative: Maikowski & Ninnemann Patentanwälte Partnerschaft mbB

(57) **Abstract**

A system for preventing overheating of a DC link capacitor in an electric vehicle, including: a DC link capacitor having a positive electrode and a negative electrode; a pair of busbars, with the positive busbar connected to the positive electrode of the DC link capacitor, and the negative busbar connected to the negative electrode of the DC link capacitor; a dielectric layer between the positive and negative busbars; a pair of DC output connectors connected to the busbars; and a heat sink positioned under the busbars and in contact with the busbars.

## Description

### Technical Filed:

The present invention relates to DC link capacitors and busbars that are used in electric vehicles.

### Background Of The Invention:

Electric vehicles use DC link capacitors as part of their power electronics. DC link capacitors are normally square or rectangular in shape and have their positive and negative conductor connections facing the IGBT power module for DC connection. This layout normally requires a set of positive and negative busbars traversing the outer form of the capacitor package, running from the Power Inverter Module (PIM)'s DC input to the DC link capacitor conductor connections. Traditionally, two designs have been used to achieve this. First, the busbars can be wrapped around the side of the capacitor to the connection terminals. Second, the busbars can instead traverse over the top of the capacitor to the connection terminals. Unfortunately, both of these approaches has the limitation that heating of the busbars can cause the capacitor to overheat (which can limit its lifespan). Another problem with these existing designs is that unwanted DC voltage ripple can be caused by higher stray inductance values caused by the length of the busbars (which extend from the Power Inverter Module (PIM) DC input to the DC link capacitor connection terminals).

What is instead desired is a system that avoids overheating of the busbars, and allows for cooling of the busbars (either directly to the chassis or to a fluid domain within the chassis if necessary). Preventing overheating of the busbars would thus extend the lifespan of the capacitor. Preferably, this busbar cooling system would have the advantage of allowing the system to operate efficiently while still allowing the busbars to be positioned immediately adjacent to the capacitor.

### Summary Of The Invention:

The present system positions the DC busbars into contact with a heat sink while also integrating the DC busbars directly into the DC-link capacitor. In preferred aspects, the DC positive busbar is integrated into the positive electrode of the capacitor winding, and the DC negative busbar is integrated into the negative electrode of the capacitor winding. Preferably, these two integrated busbars are separated by a dielectric layer. Preferably as well, the two integrated busbars share the same DC output conductors to the IGBT Power module.

Preferably, the busbars and the DC link connection terminals are connected underneath the capacitor and are positioned on top of a heat sink. In operation, any heating of the busbars is simply transferred down into the heat sink below the capacitor. An advantage of the present system includes reducing ohmic heating while lowering costs and yet still maintaining the same current carrying capability.

Advantages of the present system include lowering the heating caused by the additional length of the busbars (as compared to traditional busbars), lowering the inductance of the busbars, using the greater surface area of the busbars for cooling through contact with a heat sink, and lowering the cost of the busbars.

### Brief Description of the Drawings:

Fig. 1 is a top plan view of an existing DC link capacitor positioned adjacent to an IGBT Power Module.
Fig. 2 is a top plan view of an existing capacitor design with busbars wrapping around the side of the capacitor.
Fig. 3 is a top plan view of an existing capacitor design with busbars extending over the top of the capacitor.
Fig. 4 is a side elevation view of the present busbar system which integrates the busbars to the capacitor with the busbars connected to the DC link connection terminals and with the busbars running underneath the capacitor sitting on a heat sink.

### Detailed Description Of The Drawings:

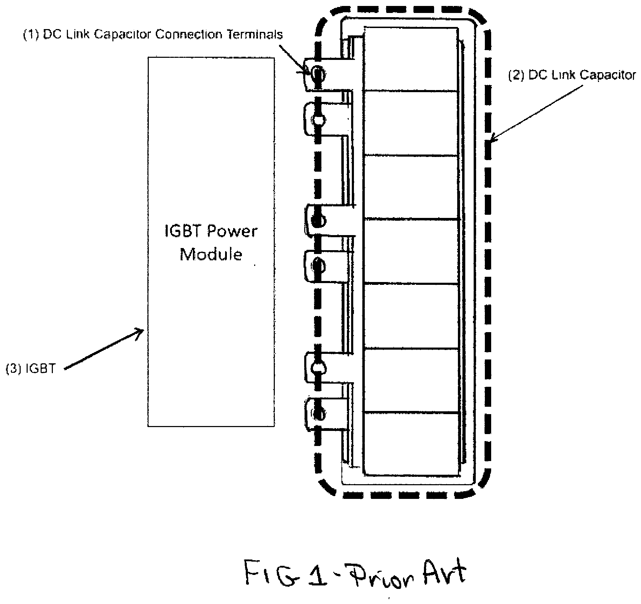

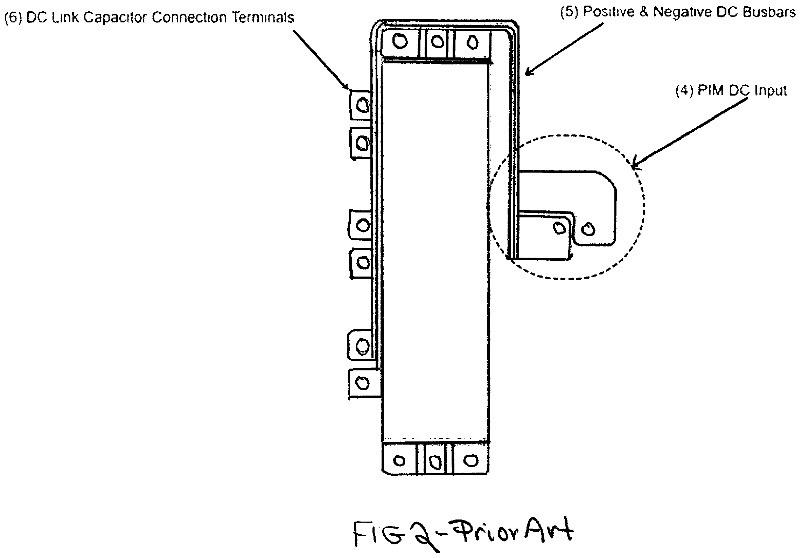

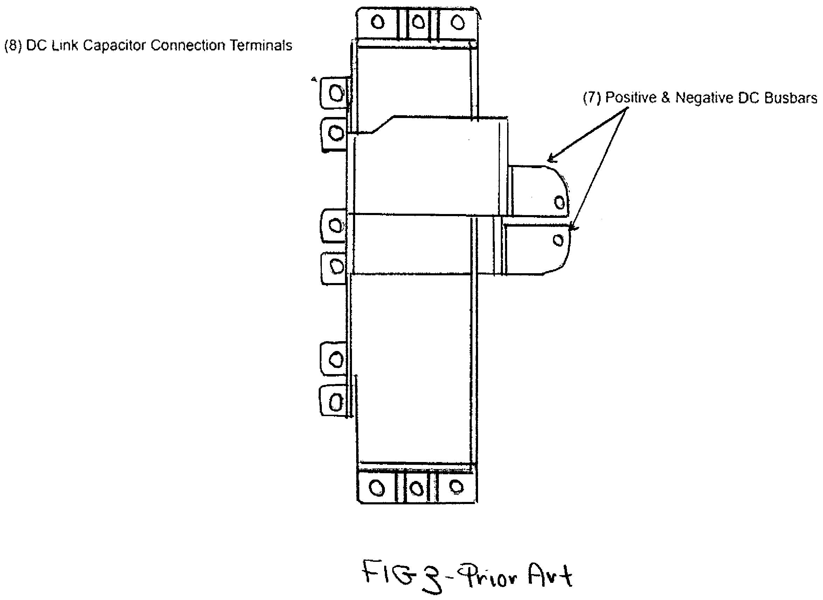

Fig. 1 is a top plan view of an existing DC link capacitor positioned adjacent to an IGBT Power Module. As can be seen, the long side of capacitor 1 faces the IGBT Power Module 3 such that the DC link capacitor terminals 3 are positioned adjacent to IGBT Power Module 3. Two different strategies for positioning the busbars are normally used with this layout. Specifically, as seen in Fig. 2, the positive and negative busbars 5 wrap around the outer sides of the capacitor from the DC link connection terminals 6 to the PIM DC input 4. Alternatively, as seen in Fig. 3, the positive and negative busbars 7 can be positioned to traverse over the top of the capacitor as shown.

As can be seen, the tight package constraints in the vehicle's power electronics system requires the busbar to closely follow the form of the capacitor. Unfortunately, heating of the busbars can therefore degrade the lifespan of the capacitor.

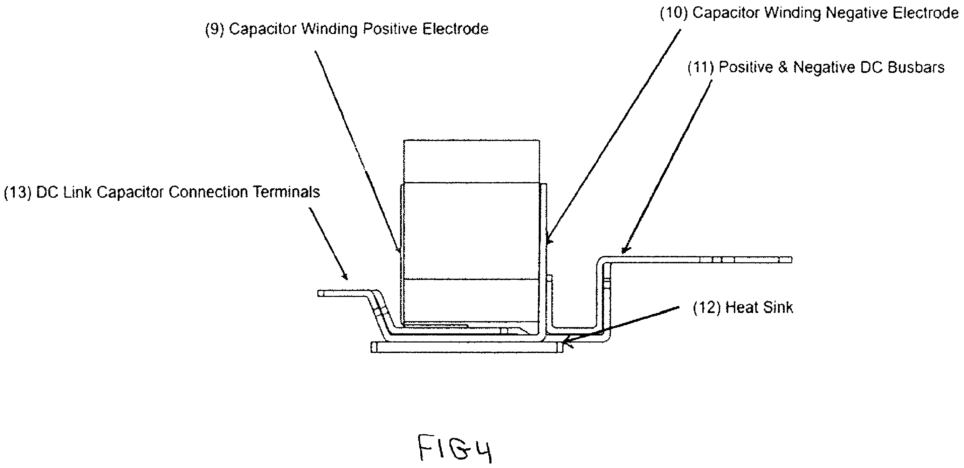

Fig. 4 is a side elevation view of the present busbar system which integrates the busbars 11 directly into the capacitor with the busbars connected to the DC link connection terminals and with the busbars running underneath the capacitor sitting on a heat sink 12. Specifically, the positive busbar is integrated into the DC link capacitor positive electrode end 9 of the capacitor winding. Similarly, the negative busbar is integrated into the DC link capacitor negative 10 of the capacitor winding. Integrated busbars 11 are separated by a dielectric layer and share the same DC output conductor terminals 13 (which is connected to the IGBT power module).

Since the DC output conductor terminals 13 already contain their own busbars, the integration of the additional busbars 11 into the system is both thermally efficient and cost effective. Preferably, the entire assembly sits on top of a heat sink 12, with the busbars 11 positioned adjacent to the heat sink 12. As a result, the heating of busbars 11 can be conducted away into heat sink 12 to protect the capacitor from unwanted heating (thus extending the capacitor lifespan). In further preferred embodiments, heat sink 12 is positioned on the chassis of the vehicle's electrical component system. This arrangement further permits heat from the busbars to be drawn away (from the capacitor) and into the chassis. Preferably, the heat sink is made of aluminum or copper.

## Claims

1. A system for preventing overheating of a DC link capacitor, comprising:
a DC link capacitor having a positive electrode and a negative electrode;
a pair of busbars, wherein a positive busbar is connected to the positive electrode of the DC link capacitor, and wherein a negative busbar is connected to the negative electrode of the DC link capacitor;
a dielectric layer between the positive and negative busbars; and
positive and negative DC output conductors extending from the respective positive and negative busbars.

2. The system of claim 1, further comprising:
a heat sink positioned under the pair of busbars and in contact with the pair of busbars.

3. The system of claim 2, wherein the heat sink is made of aluminum or copper.

4. The system of claim 2 or 3, wherein the heat sink is mounted on a chassis.

5. The system of any preceding claim, wherein the capacitor faces an IGBT power module.

6. The system of any preceding claim, wherein the pair of busbars traverse a bottom surface of the DC link capacitor.

7. The system of any preceding claim, wherein the DC link capacitor is rectangular in shape.
